# EUROPÄISCHE PATENTSCHRIFT

(11) **EP 2 387 477 B1**
(45) Veröffentlichungstag und Bekanntmachung des Hinweises auf die Patenterteilung: **23.10.2019**
(21) Anmeldenummer: 10700308.9
(22) Anmeldetag: 04.01.2010
(51) Int. Cl.: B22F 1/00, H01L 21/60

(54) **VERFAHREN ZUM HERSTELLEN EINER SINTERVERBINDUNG**
PROCESS FOR PRODUCING A SINTERED BOND
PROCÉDÉ DE PRODUCTION D'UN COMPOSÉ FRITTÉ

(30) Priorität: 14.01.2009 DE 102009000192
(43) Veröffentlichungstag der Anmeldung: 23.11.2011
(73) Patentinhaber: Robert Bosch GmbH, 70442 Stuttgart (DE)
(72) Erfinder: RITTNER, Martin, 71691 Freiberg (DE); GUENTHER, Michael, 70469 Stuttgart (DE)
(86) Internationale Anmeldenummer: PCT/EP2010/050013
(87) Internationale Veröffentlichungsnummer: WO 2010/081752

(56) Entgegenhaltungen:
- EP-A1- 1 478 216
- EP-A1- 1 916 709
- WO-A1-2004/026526
- WO-A2-2008/145930
- US-A1- 2008 160 183
- US-A1- 2008 173 398
- XU X ET AL: "Bonding behavior of copper thick films containing lead-free glass frit on aluminum nitride substrates" CERAMICS INTERNATIONAL, ELSEVIER, AMSTERDAM, NL, Bd. 30, Nr. 5, 1. Januar 2004 (2004-01-01) , Seiten 661-665, XP004515568 ISSN: 0272-8842

## Beschreibung

### Stand der Technik

Die Erfindung betrifft ein Verfahren zum Herstellen einer Sinterverbindung gemäß dem Oberbegriff des Anspruchs 1.

Ein Sinterwerkstoff sowie ein Verfahren zur Herstellung einer Sinterverbindung unter Verwendung von Hilfspartikeln sind aus der WO 2004/026526 A1 bekannt.

Zum Verbinden von elektronischen Bauteilen mit einem weiteren Fügepartner sind zurzeit bleifreie Lötverbindungen Stand der Technik. Ebenso ist es für Anwendungen mit hohen Verlustleistungen und unter hohen Umgebungstemperaturen bekannt, Silbersintertechnologie einzusetzen, wie dies beispielsweise in der DE 43 15 272 A1 beschrieben ist. Durch den Einsatz von hochschmelzenden Metallen oder Metalllegierungen in Form von Festkörperpartikeln wird die flüssige Phase im Sinterfügeprozess umgangen. Somit kann eine Sinterverbindung hergestellt werden, die hochtemperaturbeständig ist, eine elektrische und thermische Kontaktierung sicherstellt und gleichzeitig hohe Fügetemperaturen zum Aufschmelzen der zum Einsatz kommenden Silbersinterpaste vermeidet.

Da das bekannte Silbersinterverfahren mit einem hohen Prozessdruck arbeitet, gibt es Bestrebungen, diese zu reduzieren. Eine Lösungsmöglichkeit hierzu ist es, sehr kleine Strukturpartikel einzusetzen, um die dadurch erhöhte Oberflächenenergie als Triebkraft für die Sinterung zu verwenden. Es werden sogar Strukturpartikel im Nanometerbereich eingesetzt. Neben den metallischen, wachsähnlich beschichteten Strukturpartikeln weisen bekannte Sinterpasten in der Regel noch organische Lösungsmittel auf, um die pastösen Eigenschaften einer Sinterpaste zu gewährleisten. Fakultativ sind häufig zusätzlich noch weitere chemische Verbindungen oder organische Füllstoffe vorhanden.

Die Verwendung immer kleinerer metallischer Strukturpartikel führt dazu, dass der Anteil der organischen Komponenten in der Sinterpaste immer höher wird, während der Metallgehalt sinkt. Da die organischen Komponenten während des Fügeprozesses (Sinterprozesses) entfernt werden müssen, um eine Versinterung der einzelnen Strukturpartikel zu erzeugen, muss ein immer höherer organischer Anteil verdampft bzw. verbrannt werden. Dies führt dazu, dass die aus der Sinterschicht zu entfernende Gasmenge sehr groß ist, was zu einer Bildung von Poren in der Fügeschicht (Sinterschicht) führt. Diese Poren können bis zu einem gewissen Anteil vorteilhaft sein, sofern sich eine gleichmäßige Verteilung ausbildet. Bei höheren Organikanteilen kommt es vor allem im mittleren Bereich der Sinterschicht zur Bildung von großen Gasblasen, die in der Sinterschicht verbleiben. Da die Sinterschicht neben einer elektrischen und mechanischen Kontaktierung auch eine Entwärmung über eine thermische Leitfähigkeit sicherstellen muss, insbesondere wenn mittels der Sinterschicht ein Leistungshalbleiter mit einem weiteren Fügepartner verbunden wird, sind diese Gasblasen, die im Extremfall sogar die Dimension der Schichtdicke erreichen können, von Nachteil.

Der hohe Prozessdruck, der bei einem beispielsweise in der EP 0 330 895 B1 beschriebenen Sinterverfahren aufgewendet werden muss, kann uniaxial oder isostatisch aufgebracht werden. Beim aufwendigen isostatischen Verfahren muss die Fügestelle, beispielsweise mit einem Silikonmaterial, während der Druckbeaufschlagung verkapselt werden, um ein seitliches Herausquetschen der Sinterpaste zu vermeiden. Bei uniaxialer Druckbeaufschlagung ist die Fügekraft begrenzt, da die Sinterpaste ohne Verkapselung herausgequetscht werden kann. Die Verarbeitbarkeit der Sinterpaste und die Formhaltigkeit der aufgebrachten, insbesondere gedruckten Sinterpaste stehen im direkten Widerspruch. Durch einen hohen Organikanteil wird die Viskosität der Sinterpaste und somit die Aufbringbarkeit, insbesondere Druckbarkeit gewährleistet. Gleichzeitig sind diese viskosen Eigenschaften bei einem notwendigen Fügedruck unvorteilhaft, da die Sinterpaste im Anfangsstadium noch verlaufen kann.

### Offenbarung der Erfindung

Der Erfindung liegt die Aufgabe zugrunde, ein Verfahren zum Herstellen einer Sinterverbindung anzugeben, mit dem eine hochgenaue Einstellung des Spaltmaßes zwischen den miteinander zu versinternden Fügepartnern möglich ist.

Diese Aufgabe wird hinsichtlich des Verfahrens mit den Merkmalen des Anspruchs 1 gelöst.

Vorteilhafte Weiterbildungen der Erfindung sind in den Unteransprüchen angegeben.

Das Verfahren zum Herstellen einer Sinterverbindung umfasst mindestens zwei in einem Sinterprozess unter Anwendung von Sinterwerkstoff miteinander versinterte Fügepartner. Kern des Gedankens ist es, im Fügebereich wie in der nachfolgenden Beschreibung oder in den Ansprüchen beschrieben ausgebildete Hilfspartikel vorzusehen, wobei es möglich ist, einen mit derartigen Hilfspartikeln versehenen Sinterwerkstoff einzusetzen und/oder die Hilfspartikel als solches, die entweder auf zumindest einem der Fügepartner im Fügebereich aufgebracht werden und/oder auf den aufgebrachten, insbesondere aufgedruckten Sinterwerkstoff. Ziel des Vorsehens der Hilfspartikel ist es, je nach Korngröße der Hilfspartikel über diese den Abstand, d.h. das Spaltmaß, zwischen den Fügepartnern einzustellen.

Dabei wird ein Sinterwerkstoff verwendet, welcher zusätzlich zu den metallischen, mit einer organischen Beschichtung versehenen Strukturpartikeln, insbesondere Kupfer-, Silber- und/oder Goldpartikel, Hilfspartikel aufweist, wobei es sich bei den Hilfspartikeln um metallische und/oder keramische Partikel handelt, die im Gegensatz zu den Strukturpartikeln nicht organisch beschichtet sind. Je nach Anwendungszweck können die Hilfspartikel beispielsweise als feines Pulver, als Granulat oder als Pulver-Granulat-Mischung eingesetzt werden. Durch die Integration der vorgenannten Hilfspartikel in den Sinterwerkstoff wird der Organikanteil des Sinterwerkstoffs reduziert. Alternativ können die Hilfspartikel im Bereich der Fügestelle zwischen mindestens zwei Fügepartner vorgesehen werden, wobei die Hilfspartikel in diesem Fall nicht zwingend zuvor in den Sinterwerkstoff eingebracht werden müssen - es ist auch eine direkte Einbringung/Aufbringung in die Fügestelle bzw. auf zumindest einen Fügepartner möglich. Die für den Sinterwerkstoff zum Einsatz kommenden Hilfspartikel müssen nicht sortenrein sein - es kann sich auch um eine Mischung aus metallischen und keramischen Partikeln oder eine Mischung von verschiedenen metallischen und/oder keramischen Partikeln handeln. Durch das Vorsehen von wie zuvor beschrieben ausgebildeten Hilfspartikeln in dem Sinterwerkstoff und/oder unmittelbar auf mindestens einen der Fügepartner kann eine gezielte Einstellung des Sinterspaltes erfolgen. Dabei übertrifft die Korngröße der Hilfspartikel die Korngröße der Strukturpartikel um ein Vielfaches. Durch die Wahl der Korngröße und den Anteil der Hilfspartikel lässt sich ein minimaler Abstand zwischen den Fügepartnern vorgeben. So ist trotz eines notwendigen Fügedruckes eine minimale Spaltbreite zwischen den Fügepartnern gewährleistet, da eine oder mehrere Lagen der Hilfspartikel ein weiteres Zusammendrücken der Fügepartner vermeiden. Es kommt hierdurch zu einer höheren Formtreue der insbesondere gedruckten Struktur. Hierdurch kann ein Herausquetschen des Hilfspartikel aufweisenden Sinterwerkstoffs kontrolliert bzw. minimiert werden. Ein Herausdrücken des Sinterwerkstoffs kann im ungünstigsten Fall zu einem Kurzschluss führen.

Bevorzugt handelt es sich bei dem im Verfahren verwendeten Sinterwerkstoff um Sinterpaste, ganz besonders bevorzugt um Silbersinterpaste, wobei es weiter bevorzugt ist, wenn die Sinterpaste organisches Lösungsmittel zur Gewährleistung der pastösen Eigenschaften umfasst. Alternativ kann es sich bei dem Sinterwerkstoff auch um eine Pulvermischung handeln. Ebenso kann der verwendete Sinterwerkstoff als Sintermaterialvorform (Preform), also bereits als Formkörper ausgebildet sein.

Ein beim Verfahren verwendeter Sinterwerkstoff wird bevorzugt bei Produkten eingesetzt, bei denen eine elektrische Verbindung zu elektrischen Bauelementen hergestellt werden muss. Insbesondere können bisher zum Einsatz kommende Lotverbindungen durch eine mittels im Verfahren verwendeten Sinterwerkstoffs hergestellte Sinterverbindung substituiert werden. Die mittels des verwendeten Sinterwerkstoffs hergestellte Sinterverbindung kann bei hohen Temperaturen eingesetzt werden und/oder bei Bauelementen mit hohen Verlustleistungen.

Dadurch können bisher auftretende Lebensdauereinschränkungen überwunden werden. Dies ist insbesondere bei der Ausbildung der Hilfspartikel als Abstandhalter möglich, da ein definiertes Spaltmaß trotz eines hohen Prozessdruckes eingehalten werden kann. Beispiele für Einsatzgebiete sind: Leistungsendstufen von elektrischen Servolenkungen, Leistungsendstufen von universellen Wechselrichteinheiten, Regelelektroniken, insbesondere am Starter und/oder Generator, Einpressdioden an Generatorschildern, hochtemperaturstabile Halbleiter, wie Siliziumkarbid, oder auch Sensoren, die unter hoher Temperatur betrieben werden und eine sensornahe Auswerteelektronik benötigen. Auch ist der Einsatz bei Halbleiterdioden möglich. Auch ist der Sinterwerkstoff bei Modulen für Wechselrichter, insbesondere an Photovoltaikanlagen, einsetzbar.

Da aufgrund der Hilfspartikel auch ein geringer Porengehalt eingestellt werden kann und geeignete thermische Ausdehnungskoeffizienten realisierbar sind, können höhere Einsatztemperaturen der erhaltenen Sinterverbindung realisiert werden. Aufgrund der Minimierung der Poren kann auch die Fügefläche erhöht werden, die derzeit durch die Entgasungsproblematik beschränkt ist. Hierdurch können optimale Wärmeübertragungseigenschaften erreicht werden.

In Weiterbildung der Erfindung zeichnen sich die zum Einsatz kommenden Hilfspartikel dadurch aus, dass deren Schmelztemperatur größer ist als eine Sinterprozesstemperatur, um ein Aufschmelzen der Hilfspartikel beim Sinterprozess zu vermeiden. Ganz besonderes bevorzugt ist es, wenn die Schmelztemperatur der Hilfspartikel größer ist als die der zum Einsatz kommenden Strukturpartikel. Besonders bevorzugt liegt die bei dem Sinterprozess zur Anwendung kommende Temperatur unter 300°C, vorzugsweise unter 250°C, ganz besonders bevorzugt unter 100°C. Technisch wünschenswert ist der zur Anwendung kommende Prozessdruck null, was jedoch kaum realisierbar ist. Bevorzugt beträgt der Prozessdruck maximal 40 MPa, vorzugsweise weniger als 15 MPa, weiter bevorzugt weniger als 10 MPa, oder weniger als 6 MPa, oder weniger als 3 MPa, oder weniger als 1 MPa, oder weniger als 0,5 MPa.

Besonders zweckmäßig ist es, wenn die Hilfspartikel derart ausgebildet sind, dass diese während des Sinterprozesses mit den Strukturpartikeln versintern. Hierzu können die Hilfspartikel beispielsweise eine sinterfähige Oberfläche aufweisen, die beispielsweise mittels einer geeigneten Beschichtung realisierbar ist. Auch ist es möglich, die Hilfspartikel derart auszuwählen, dass diese in die Strukturpartikel eindiffundieren.

Besonders bevorzugt ist es, wenn es sich bei den Hilfspartikeln um keramische und/oder metallische Partikel handelt. Im Falle des Vorsehens von Hilfspartikeln kann es vorteilhaft sein, diese zu beschichten, insbesondere metallisch zu beschichten, vorzugsweise mit dem Metall und/oder mit einem Edelmetall oder mit Nickel, ganz besonders bevorzugt mit einem Phosphoranteil aufweisenden Nickel. Hierdurch kann die Haftung der Hilfspartikel in dem verwendeten Sinterwerkstoff verbessert werden. Bei der Verwendung von Metallpartikeln als Hilfspartikel können diese aus demselben Material ausgebildet sein wie die Strukturpartikel (jedoch ohne organische Beschichtung). Dies hat zwar keine Veränderung des thermischen Ausdehnungsverhaltens zur Folge, reduziert jedoch das Volumen der beim Sinterprozess entstehenden Gase, was eine dichtere Sinterschicht zur Folge hat.

Im Hinblick auf die Ausbildung der Strukturpartikel gibt es ebenfalls unterschiedliche Möglichkeiten. Ganz besonders bevorzugt ist eine Ausführungsform, bei der es sich bei den Strukturpartikeln um Silberpartikel handelt. Zusätzlich oder alternativ können als Kupferpartikel, Goldpartikel oder Palladiumpartikel ausgebildete Strukturpartikel vorgesehen sein. Auch ist es möglich, eine Mischung aus vorgenannten Partikeln als Strukturpartikel zu verwenden. Zusätzlich oder alternativ ist es möglich, die Strukturpartikel aus Legierungen auszubilden, die bevorzugt mindestens eines der vorgenannten Metalle umfassen.

Bei der Verwendung von keramischen Partikeln als Hilfspartikel sollte die Wärmeleitfähigkeit der Hilfspartikel gewährleistet sein. Deshalb eignen sich hier insbesondere Materialien wie Aluminiumoxid (auch dotiert), Aluminiumnitrid, Berylliumoxid und Siliziumnitrid. Um die elektrische Leitfähigkeit von keramischen Hilfspartikeln nicht zu verschlechtern, können auch elektrisch leitfähige Keramiken, wie beispielsweise Borkarbid oder Siliziumkarbid eingesetzt werden.

Die Hilfspartikel sind als Formkörper mit bestimmten geometrischen Formen ausgebildet. So sind die Hilfspartikel kugelförmig, quaderförmig, zylindrisch etc. konturiert. Dies kann beispielsweise durch Ausstanzen der Hilfspartikel aus einem Blech erreicht werden, wobei es in diesem Fall besonders bevorzugt ist, wenn das Blech bzw. die Formkörper mit einer Beschichtung versehen werden, die eine Versinterung der Hilfspartikel mit den Strukturpartikeln ermöglicht, wobei die Beschichtung jedoch auf keinen Fall organischer Natur sein darf, um nicht zusätzlich ein Gasvolumen beim Sinterprozess zu erzeugen. Insgesamt ist dadurch der Einsatz von unregelmäßig konturierten Hilfspartikeln als Abstandhalter möglich. Die Hilfspartikel weisen eine wesentlich größere, insbesondere um ein Vielfaches größere Korngröße auf als die Strukturpartikel. Ganz besonders bevorzugt sind die Hilfspartikel so groß gewählt, dass sie gleichzeitig beide miteinander zu fügenden Fügepartner berühren und somit die Spaltbreite direkt definieren.

Hergestellt wird eine Sinterverbindung, umfassend mindestens zwei Fügepartner, die in einem Fügebereich miteinander versintert sind. Die hergestellte Sinterverbindung zeichnet sich dadurch aus, dass Hilfspartikel im Fügebereich verwendet sind, die bei entsprechender Korngröße eine Abstandhalterfunktion zur Einstellung des Fügespaltes übernehmen.

Dabei weisen die Hilfspartikel eine, vorzugsweise um ein Vielfaches, größere Korngröße auf als die Strukturpartikel. In einer besonders bevorzugten Ausführungsform berühren die Hilfspartikel gleichzeitig beide Fügepartner.
Im Hinblick auf die Ausbildung der mindestens zwei miteinander versinterten Fügepartner gibt es unterschiedliche Möglichkeiten. So kann zumindest einer der Fügepartner beispielsweise als elektronisches Bauelement, insbesondere als Halbleiterbauelement, vorzugsweise als Leistungshalbleiterbauelement, ausgebildet sein. Dabei ist es besonders bevorzugt, wenn dieses Bauteil Silizium, Siliziumkarbid, Siliziumnitrid, Galliumphosphid oder Galliumarsenid umfasst. Weiter bevorzugt ist es, wenn ein derartiges Bauteil mit einem elektrischen Schaltungsträger mittels einer Sinterschicht verbunden wird. Auch ist es möglich, einen, insbesondere bestückten, Schaltungsträger und eine Grundplatte und/oder ein Gehäuse mittels einer Sinterschicht zu versintern. Auch kann ein Bauelement, insbesondere ein elektronisches Bauelement, mit zwei, vorzugsweise voneinander abgewandten Sinterschichten, sandwichartig zwischen zwei Fügepartner eingebracht werden, die eine elektrische Kontaktierung des Bauelementes nach oben und/oder unten sicherstellen. Im Falle der Ausbildung eines der Fügepartner als Grundplatte ist es bevorzugt, dieses als sogenanntes DCB-Substrat oder AMB-Substrat oder IMS-Substrat oder PCB-Substrat oder LTCC-Substrat oder Standardkeramiksubstrat auszubilden.

Weitere Vorteile, Merkmale und Einzelheiten der Erfindung ergeben sich aus der nachfolgenden Beschreibung bevorzugter Ausführungsbeispiele sowie anhand der Zeichnungen.

Diese zeigen in:
- Fig. 1:: eine mögliche Ausführungsform einer Sinterverbindung umfassend allgemein Hilfspartikel mit zwei Fügepartnern,
- Fig. 2:: eine alternative Ausführungsform einer Sinterverbindung umfassend allgemein Hilfspartikel mit insgesamt drei Fügepartnern und zwei Sinterschichten,
- Fig. 3:: eine alternative Sinterverbindung, bei der kugelförmige Hilfspartikel als Abstandhalter vorgesehen sind,
- Fig. 4:: eine weitere alternative Sinterverbindung, bei der die kugelförmigen, als Abstandhalter dienenden Sinterpartikel mit einer nicht-organischen Beschichtung versehene Partikel sind,
- Fig. 5:: ein weiteres alternatives Ausführungsbeispiel einer Sinterverbindung, bei der die als Abstandhalter dienenden Hilfspartikel quaderförmig ausgebildet sind,
- Fig. 6:: ein weiteres alternatives Ausführungsbeispiel einer Sinterverbindung, bei dem die Hilfspartikel als grobkörniges Pulver ausgebildet sind, und
- Fig. 7:: eine Darstellung einer Sinterverbindung mit kugelförmigen Hilfspartikeln, die zwei Sinterschichten miteinander verbinden.

In den Figuren sind gleiche Elemente und Elemente mit der gleichen Funktion mit den gleichen Bezugszeichen gekennzeichnet.

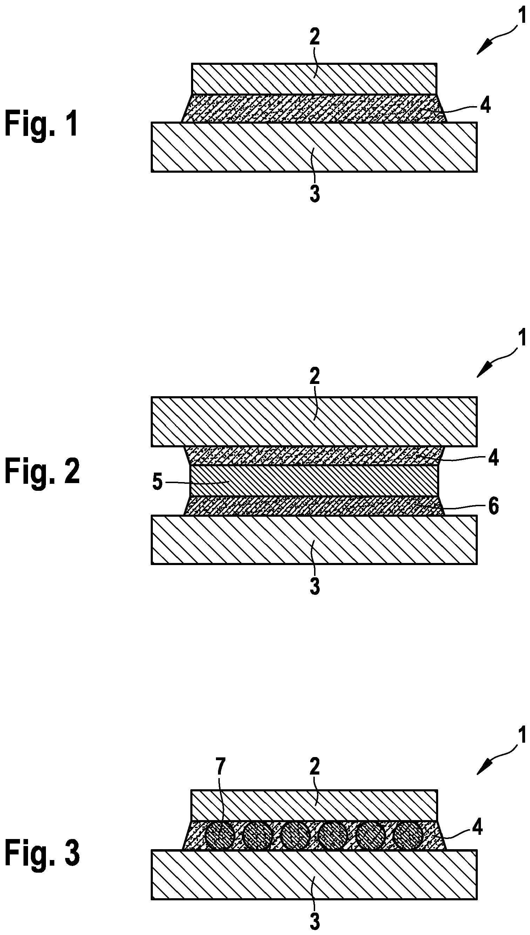

In Fig. 1 ist eine Sinterverbindung 1 gezeigt. Diese umfasst einen in der Zeichnungsebene oberen ersten Fügepartner 2 sowie einen darunter befindlichen zweiten Fügepartner 3. Die beiden Fügepartner 2, 3 sind über eine aus einem nicht dargestellten Sinterwerkstoff hergestellte Sinterschicht 4 miteinander versintert. Der Sinterwerkstoff enthielt vor dem Sinterprozess und die daraus resultierende Sinterschicht 4 enthält nach dem Sinterprozess neben metallischen Strukturpartikel Hilfspartikel, die nicht-organisch beschichtet waren/sind. Bei dem zum Einsatz kommenden Sinterwerkstoff kann es sich alternativ um eine Sinterpaste, eine Pulvermischung oder ein Sinterformteil handeln. Die Hilfspartikel dienen zur Reduzierung des Organikanteils und damit zur Reduzierung der Gasbildung beim Sintern der Sinterpartner. Die Hilfspartikel zeichnen sich im Wesentlichen dadurch aus, dass sie gegenüber dem Sinterprozess inert sind, d.h. diesen zumindest näherungsweise unverändert überstehen. Bei dem ersten Fügepartner 2 handelt es sich beispielsweise um ein elektronisches Bauelement, beispielsweise eine Leistungshalbleiter, und bei dem zweiten Fügepartner 3 beispielsweise um einen Schaltungsträger. Auch ist es möglich, dass es sich bei dem ersten Fügepartner 2 um einen bestückten Schaltungsträger und bei dem zweiten Fügepartner 3 um eine Grundplatte (Wärmesenke) handelt.

In Fig. 2 ist eine alternative Sinterverbindung 1 gezeigt. Diese umfasst neben den ersten beiden, hier außen angeordneten Fügepartnern 2, 3 einen dritten Fügepartner 5, bei dem es sich in dem gezeigten Ausführungsbeispiel beispielsweise um ein elektronisches Bauelement handelt. Der erste und der zweite Fügepartner 2, 3 sind bevorzugt jeweils als Schaltungsträger oder Grundplatte oder Gehäuse etc. ausgebildet. Sowohl zwischen dem ersten Fügepartner 2 und dem dritten Fügepartner 5 als auch zwischen dem dritten Fügepartner 5 und dem zweiten Fügepartner 3 befindet sich jeweils eine Sinterschicht 4, 6, die jeweils aus einem Sinterwerkstoff hergestellt wurde. Dieser Sinterwerkstoff enthielt metallische oder keramische, nicht organisch beschichtete Hilfspartikel, die beim Sinterprozess unter Anwendung von Druck und Temperatur nicht ausgasen.

In den Fig. 3 bis 6 sind weitere Ausführungsbeispiele von Sinterverbindungen 1, umfassend jeweils zwei miteinander durch Sintern gefügte Fügepartner 2, 3 gezeigt. Die zwischen den Fügepartnern 2, 3 befindliche Sinterschicht 4 wurde jeweils hergestellt aus einem Sinterwerkstoff (beispielsweise eine Sinterpaste, eine Pulvermischung oder ein Sinterformteil), umfassend metallische oder keramische, nicht-organisch beschichtete, während des Sinterprozesses nicht ausgasende Hilfspartikel 7. In den Ausführungsbeispielen gemäß den Fig. 3 bis 6 dienen die Hilfspartikel 7 als Abstandhalter zur Einstellung des Spaltmaßes des Sinterspaltes bzw. der Schichtdicke der Sinterschicht 4. Die schematisch dargestellten Hilfspartikel 7 weisen in sämtlichen Ausführungsbeispielen gemäß den Fig. 3 bis 6 eine wesentlich größere Korngröße auf als die aus Übersichtlichkeitsgründen nicht eingezeichneten Strukturpartikel der Sinterschicht 4. Die Hilfspartikel 7 zeichnen sich im Wesentlichen dadurch aus, dass sie gegenüber dem Sinterprozess inert sind, d.h. diesen zumindest näherungsweise unverändert überstehen.

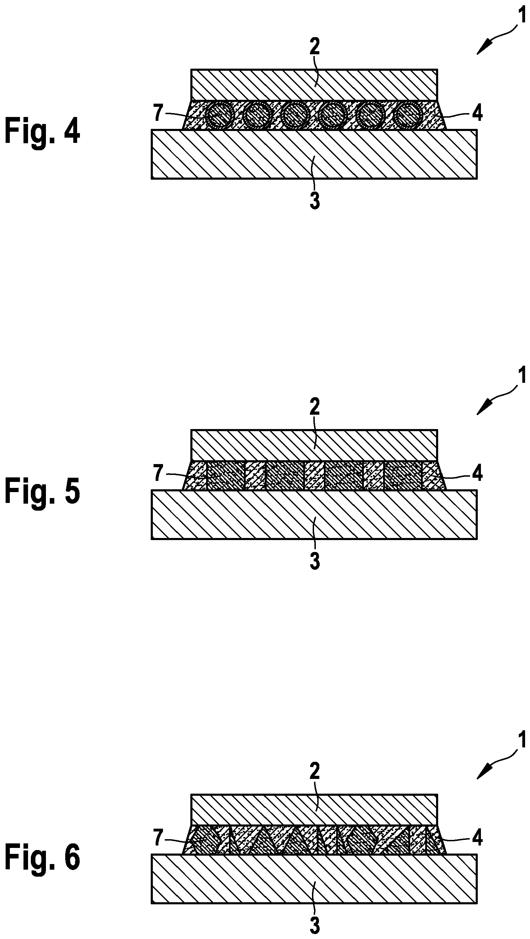

Bei dem Ausführungsbeispiel gemäß Fig. 3 weisen die Hilfspartikel 7 eine kugelförmige Gestalt auf, ebenso wie bei dem Ausführungsbeispiel gemäß Fig. 4, mit dem Unterschied, dass die Hilfspartikel 7 in dem Ausführungsbeispiel gemäß Fig. 4 beschichtet sind. Bevorzugt handelt es sich um metallisch beschichtete Keramikpartikel.

Bei dem Ausführungsbeispiel gemäß Fig. 5 sind quaderförmig oder zylindrisch konturierte Hilfspartikel 7 vorgesehen und bei dem Ausführungsbeispiel gemäß Fig. 6 ein grobkörniges Pulver, wobei die einzelnen Hilfspartikel 7 unregelmäßig konturiert sind.

Bei den in den Fig. 3 bis 5 dargestellten Hilfspartikeln 7 kann es sich auch beispielsweise um Formkörper handeln, die weiter beispielsweise aus Blechen gestanzt sind. Bevorzugt sind diese Formkörper mit einer Beschichtung (Oberflächenfinish) versehen, wie dies beispielsweise in Fig. 4 dargestellt ist, um zu den Strukturpartikeln des Sinterwerkstoffs bzw. der Sinterschicht eine feste Verbindung eingehen zu können.

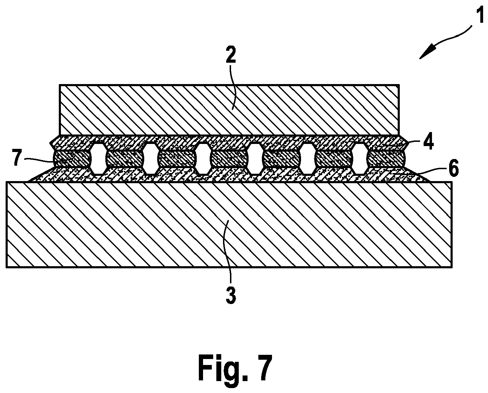

In Fig. 7 ist ein weiteres Ausführungsbeispiel einer Sinterverbindung 1 gezeigt. Zu erkennen sind zwei miteinander durch Sintern fest verbundene Fügepartner 2, 3, wobei auf jeweils einer Seite jedes Fügepartners 2, 3 eine Sinterschicht 4, 6 ausgebildet ist, wobei die Sinterschichten 4, 6 sich in dem gezeigten Ausführungsbeispiel nicht unmittelbar berühren, sondern über vergleichsweise groß dimensionierte Hilfskörper 7 miteinander verbunden sind, wobei die Hilfskörper 7 an die Strukturpartikel der Sinterschichten 4, 6 angesintert sind.

## Patentansprüche

1. Verfahren zum Herstellen einer Sinterverbindung (1), bei dem ein erster und mindestens ein zweiter Fügepartner (2, 3, 5) in einem Sinterprozess unter Druck- und Temperatureinwirkung unter Verwendung von Sinterwerkstoff miteinander versintert werden, wobei ein Sinterwerkstoff verwendet wird, der metallische mit einer organischen Beschichtung versehene Strukturpartikeln und nicht organisch beschichtete, metallische und/oder keramische Hilfspartikel (7) aufweist, wobei die Hilfspartikel (7) beim Sinterprozess keine Gase abgeben,
**dadurch gekennzeichnet,**
**dass** die Hilfspartikel (7) als Abstandshalter zur Einstellung eines definierten Spaltmaßes zwischen den Fügepartner (2, 3, 5) verwendet werden und das Spaltmaß nach dem Sinterprozess auf eine Lage der Hilfspartikel (7) eingestellt wird, indem ein Teil der Hilfspartikel (7) beide Fügepartner berührt, wobei die Hilfspartikel (7) eine um ein Vielfaches größere Korngröße aufweisen als die Strukturpartikel und die Hilfspartikel (7) gegenüber dem Sinterprozess inert sind, das heißt den Sinterprozeß zumindest näherungsweise unverändert überstehen.

2. Verfahren nach Anspruch 1,
**dadurch gekennzeichnet,**
**dass** die Hilfspartikel (7) als kugelförmige, quaderförmige, zylindrische oder unregelmäßig konturierte Formkörper ausgebildet sind.

3. Verfahren nach Anspruch 1 oder 2,
**dadurch gekennzeichnet,**
**dass** ein Sinterwerkstoff verwendet wird, der als vorzugsweise mindestens ein organisches Lösungsmittel umfassende Sinterpaste, oder als Pulvermischung, oder als Sintermaterialvorform ausgebildet ist.

4. Verfahren nach einem der vorhergehenden Ansprüche,
**dadurch gekennzeichnet,**
**dass** die Schmelztemperatur und/oder die Zersetzungstemperatur der Hilfspartikel (7) größer ist als eine Sinterprozesstemperatur, vorzugsweise größer ist als die Schmelztemperatur bzw. Zersetzungstemperatur der Strukturpartikel.

5. Verfahren nach einem der vorhergehenden Ansprüche,
**dadurch gekennzeichnet,**
**dass** die Hilfspartikel (7) derart ausgebildet sind, dass diese während des Sinterprozesses mit den Strukturpartikeln versintern, insbesondere durch das Vorsehen einer sinterfähigen Oberfläche oder Beschichtung und/oder durch Eindiffundieren.

6. Verfahren nach einem der vorhergehenden Ansprüche,
**dadurch gekennzeichnet,**
**dass** Hilfspartikel (7) verwendet werden, die metallisch und/oder keramisch ausgebildet sind und insbesondere mit dem Metall der Strukturpartikel oder einem Edelmetall oder Nickel, bevorzugt mit einem Phosphoranteil, beschichtet sind.

7. Verfahren nach einem der vorhergehenden Ansprüche,
**dadurch gekennzeichnet,**
**dass** Sinterwerkstoff verwendet wird, bei dem die Strukturpartikel als Silberpartikel, Kupferpartikel, Goldpartikel, Platinpartikel oder Palladiumpartikel oder einer Mischung der vorgenannten Partikel und/oder als Legierung mit mindestens eines der vorgenannten Metallen ausgebildet sind.

8. Verfahren nach einem der vorhergehenden Ansprüche,
**dadurch gekennzeichnet,**
**dass** Sinterwerkstoff verwendet wird, bei dem die Hilfspartikel (7) als Wolframpartikel, Goldpartikel, Silberpartikel, Aluminiumoxidpartikel, Aluminiumnitridpartikel, Berylliumoxidpartikel, Siliziumnitridpartikel, Borcarbidpartikel oder Siliziumkarbidpartikel oder als Mischung vorgenannter Partikel ausgebildet sind.

9. Sinterverbindung hergestellt mit einem Verfahren nach einem der vorhergehenden Ansprüche, umfassend einen ersten Fügepartner (2) und mindestens einen zweiten Fügepartner (3), die in einem Fügebereich miteinander versintert sind, wobei ein Spaltmaß zwischen den beiden Fügepartnern auf eine Lage der Hilfspartikel (7) eingestellt ist, indem ein Teil der Hilfspartikel (7) beide Fügepartner berührt.

10. Sinterverbindung nach Anspruch 9,
**dadurch gekennzeichnet,**
**dass** der erste und/oder der zweite, vorzugsweise beschichtete, insbesondere mit Nickel-Phosphor, Silber und/oder Gold beschichtete, Fügepartner (2, 3) als elektronisches Bauelement, vorzugsweise aus Silizium, Siliziumkarbid, Galliumnitrid, Galliumindiumphosphit, oder Galliumarsenid, oder als elektrischer, insbesondere bestückter, Schaltungsträger, oder als Gehäuse, oder als, insbesondere als DCB-, AMB-, IMS-, PCB-, LTCC-, Standartkeramik-Substrat ausgebildete, Grundplatte ausgebildet sind/ist.

11. Sinterverbindung nach Anspruch 9 oder 10,
**dadurch gekennzeichnet, dass**
mehr als die Hälfte der Hilfspartikel (7) beide Fügepartner (2, 3) berührt.

## Claims

1. Process for producing a sintered bond (1), in which a first join partner and at least one further join partner (2, 3, 5) are sintered together in a sintering process under the action of pressure and heat using sintering material, where a sintering material comprising metallic structured particles provided with an organic coating and metallic and/or ceramic auxiliary particles (7) which are not organically coated is used, where the auxiliary particles (7) do not give off any gases during the sintering process,
**characterized in that**
the auxiliary particles (7) are used as spacers to set a defined spacing between the join partners (2, 3, 5) and the spacing after the sintering process is set to one layer of the auxiliary particles (7) by part of the auxiliary particles (7) touching both join partners, where the auxiliary particles (7) have a particle size which is a multiple of the particle size of the structured particles and the auxiliary particles (7) are inert in respect of the sintering process, that is to say they withstand the sintering process at least approximately unaltered.

2. Process according to Claim 1, **characterized in that** the auxiliary particles (7) are configured as spherical, cuboidal, cylindrical or irregularly contoured shaped bodies.

3. Process according to Claim 1 or 2, **characterized in that** a sintering material which is in the form of a sintering paste which preferably comprises at least one organic solvent or in the form of a powder mixture or in the form of sintering material preform is used.

4. Process according to any of the preceding claims, **characterized in that** the melting point and/or the decomposition temperature of the auxiliary particles (7) is greater than a sintering process temperature, preferably greater than the melting point or decomposition temperature of the structured particles.

5. Process according to any of the preceding claims, **characterized in that** the auxiliary particles (7) are configured so that they sinter together with the structured particles during the sintering process, in particular by provision of a sinterable surface or coating and/or by diffusion.

6. Process according to any of the preceding claims, **characterized in that** auxiliary particles (7) which are metallic and/or ceramic and are, in particular, coated with the metal of the structured particles or a noble metal or nickel, preferably with a proportion of phosphorus, are used.

7. Process according to any of the preceding claims, **characterized in that** sintering material in which the structured particles are configured as silver particles, copper particles, gold particles, platinum particles or palladium particles or a mixture of the abovementioned particles and/or as alloy comprising at least one of the abovementioned metals is used.

8. Process according to any of the preceding claims, **characterized in that** sintering material in which the auxiliary particles (7) are configured as tungsten particles, gold particles, silver particles, aluminium oxide particles, aluminium nitride particles, beryllium oxide particles, silicon nitride particles, boron carbide particles or silicon carbide particles or as a mixture of the abovementioned particles is used.

9. Sintered bond produced by a process according to any of the preceding claims, comprising a first join partner (2) and at least one second join partner (3) which are sintered to one another in a join region, wherein a spacing between the two join partners is set to one layer of the auxiliary particles (7) by part of the auxiliary particles (7) touching both join partners.

10. Sintered bond according to Claim 9, **characterized in that** the first and/or the second, preferably coated, in particular nickel-phosphorus-, silver- and/or gold-coated, join partner (2, 3) is/are configured as electronic component, preferably composed of silicon, silicon carbide, gallium nitride, gallium-indium phosphite or gallium arsenide, or as electrical circuit board, in particular equipped with components, or as housing or as baseplate, in particular configured as DCB, AMB, IMS, PCB, LTCC or standard ceramic substrate.

11. Sintered bond according to Claim 9 or 10, **characterized in that** more than half of the auxiliary particles (7) touch both join partners (2, 3).

## Revendications

1. Procédé de fabrication d'une liaison frittée (1), avec lequel un premier et au moins un deuxième partenaire de jointoiement (2, 3, 5) sont frittés l'un à l'autre dans un processus de frittage sous action de la pression et de la température en utilisant un matériau de frittage, le matériau de frittage utilisé possédant des particules structurales métalliques pourvues d'un revêtement organique et des particules auxiliaires (7) métalliques et/ou céramiques sans revêtement organique, les particules auxiliaires (7) ne délivrant pas de gaz lors du processus de frittage,
**caractérisé en ce que**
les particules auxiliaires (7) sont utilisées comme entretoises pour le réglage d'une cote d'interstice définie entre les partenaires de jointoiement (2, 3, 5) et la cote d'interstice est réglée après le processus de frittage à une couche des particules auxiliaires (7) du fait qu'une partie des particules auxiliaires (7) est en contact avec les deux partenaires de jointoiement, les particules auxiliaires (7) possédant une granulométrie plusieurs fois supérieure à celle des particules structurales et les particules auxiliaires (7) étant inertes par rapport au processus de frittage, c'est-à-dire qu'elles ressortent au moins approximativement inchangées du processus de frittage.

2. Procédé selon la revendication 1, **caractérisé en ce que** les particules auxiliaires (7) sont réalisées sous la forme de corps moulés sphériques, parallélépipédiques, cylindriques ou au contour irrégulier.

3. Procédé selon la revendication 1 ou 2, **caractérisé en ce que** le matériau de frittage utilisé est réalisé sous la forme d'une pâte de frittage comprenant de préférence au moins un solvant organique, ou sous la forme d'un mélange de poudres ou sous la forme d'une préforme en matière de frittage.

4. Procédé selon l'une des revendications précédentes, **caractérisé en ce que** la température de fusion et/ou la température de décomposition des particules auxiliaires (7) est supérieure à une température de processus de frittage, de préférence supérieure à la température de fusion ou à la température de décomposition des particules structurales.

5. Procédé selon l'une des revendications précédentes, **caractérisé en ce que** les particules auxiliaires (7) sont configurées de telle sorte que celles-ci s'agglomèrent par frittage avec les particules structurales pendant le processus de frittage, notamment par la présence d'une surface ou d'un revêtement apte au frittage et/ou par diffusion à l'intérieur.

6. Procédé selon l'une des revendications précédentes, **caractérisé en ce que** les particules auxiliaires (7) utilisées sont de configuration métallique et/ou céramique et sont notamment revêtues du métal des particules structurales ou d'un métal noble ou de nickel, de préférence avec une part de phosphore.

7. Procédé selon l'une des revendications précédentes, **caractérisé en ce que** les particules structurales du matériau de frittage utilisé sont réalisées sous la forme de particules d'argent, de particules de cuivre, de particules d'or, de particules de platine ou de particules de palladium ou d'un mélange des particules mentionnées précédemment et/ou sous la forme d'un alliage avec au moins l'un des métaux mentionnés précédemment.

8. Procédé selon l'une des revendications précédentes, **caractérisé en ce que** les particules auxiliaires (7) du matériau de frittage utilisé sont réalisées sous la forme de particules de tungstène, de particules d'or, de particules d'argent, de particules d'oxyde d'aluminium, de particules de nitrure d'aluminium, de particules d'oxyde de béryllium, de particules de nitrure de silicium, de particules de carbure de bore ou de particules de carbure de silicium ou d'un mélange des particules mentionnées précédemment.

9. Liaison frittée produite avec un procédé selon l'une des revendications précédentes, comprenant un premier partenaire de jointoiement (2) et au moins un deuxième partenaire de jointoiement (3), lesquels sont frittés l'un à l'autre dans une zone de jointoiement, une cote d'interstice entre les deux partenaires de jointoiement étant réglée à une couche des particules auxiliaires (7) du fait qu'une partie des particules auxiliaires (7) est en contact avec les deux partenaires de jointoiement.

10. Liaison frittée selon la revendication 9, **caractérisée en ce que** le premier et/ou le deuxième partenaires de jointoiement (2, 3), de préférence muni d'un revêtement, notamment muni d'un revêtement de nickel-phosphore, d'argent et/ou d'or, est/sont réalisés sous la forme d'un composant électronique, de préférence en silicium, en carbure de silicium, en nitrure de gallium, en phosphure de gallium et d'indium ou en arséniure de gallium, ou sous la forme d'un porte-circuit électrique, notamment garni, ou sous la forme d'un boîtier, ou sous la forme d'une plaque de base, notamment réalisée sous la forme d'un substrat DCB, AMB, IMS, PCB, LTCC, céramique standard.

11. Liaison frittée selon la revendication 9 ou 10, **caractérisée en ce que** plus de la moitié des particules auxiliaires (7) est en contact avec les deux partenaires de jointoiement (2, 3).
